(19) Europäisches Patentamt / European Patent Office / Office européen des brevets

(11) **EP 3 324 455 B1**

(12) **FASCICULE DE BREVET EUROPEEN**

(45) Date de publication et mention de la délivrance du brevet:
**20.03.2019 Bulletin 2019/12**

(51) Int Cl.:
***H01L 45/00*** *(2006.01)*

(21) Numéro de dépôt: **17200976.3**

(22) Date de dépôt: **10.11.2017**

(54) **COMMUTATEUR A MATERIAU A CHANGEMENT DE PHASE**

UMSCHALTER AUS EINEM MATERIAL MIT PHASENÄNDERUNG

SWITCH WITH PHASE-CHANGE MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.11.2016 FR 1661093**

(43) Date de publication de la demande:
**23.05.2018 Bulletin 2018/21**

(73) Titulaire: **Commissariat à l'énergie atomique et aux énergies alternatives 75015 Paris (FR)**

(72) Inventeurs:
• **BELOT, Didier**
  **38140 RIVES (FR)**
• **LARIE, Aurélien**
  **38000 GRENOBLE (FR)**
• **MARTINEAU, Baudouin**
  **38000 GRENOBLE (FR)**

(74) Mandataire: **Brevalex**
  **95, rue d'Amsterdam**
  **75378 Paris Cedex 8 (FR)**

(56) Documents cités:
US-A1- 2008 007 995    US-A1- 2010 148 141
US-A1- 2014 191 181    US-A1- 2016 035 973

**Description**

**DOMAINE TECHNIQUE ET ART ANTÉRIEUR**

L'invention concerne le domaine des commutateurs électroniques, formés d'un ou plusieurs interrupteurs réalisés à partir de matériaux à changement de phase, ou PCM (« Phase Change Material » en anglais). L'invention porte notamment sur des commutateurs utilisés dans le domaine RF (radiofréquence). L'invention porte notamment sur le contrôle de la commutation d'un commutateur utilisant une technologie à base de PCM. L'invention concerne également le domaine des dispositifs d'adaptation et/ou de déphasage de lignes de transmission.

Un commutateur à PCM utilisé en tant qu'interrupteur fonctionne grâce à deux états stables possibles du PCM :

- un état amorphe à haute résistivité (par exemple de plusieurs MΩ), qui permet de mettre le commutateur à un état bloqué ;
- un état cristallin à faible résistivité (par exemple moins de 10 mΩ), qui permet de mettre le commutateur à un état passant.

Pour passer d'un état cristallin à un état amorphe, le PCM est chauffé à des températures élevées (par exemple entre environ 600 °C et 1000 °C, selon le PCM utilisé) pendant une très courte durée (par exemple comprise entre environ 10 ns et 100 ns). Pour passer de l'état amorphe à l'état cristallin, le PCM est chauffé plus faiblement (par exemple entre environ 150 °C et 250 °C, selon le matériau utilisé) mais pendant une durée plus longue que celle du passage de l'état cristallin à l'état amorphe (par exemple entre environ 1 µs et 10 ms).

Les deux états du PCM, cristallin et amorphe, étant stables, il n'est pas nécessaire de maintenir un courant ou une tension de commande sur le commutateur pour le maintenir à l'état passant ou bloqué, ce qui permet une économie d'énergie par rapport à d'autres technologies de commutation telles que celles faisant appel à des transistors FET ou des diodes PIN.

Il existe plusieurs structures de chauffage direct ou indirect intégrées dans les composants PCM et permettant de réaliser le changement d'état du PCM.

Le document Y. Shim et al., "RF switches using phase change materials ", Proc. IEEE Int. Conf. Microelectromech. Syst., Taipei, Taiwan, Jan. 2013, pp. 237-240, décrit la réalisation d'un commutateur RF comprenant un ou plusieurs vias réalisés à partir GeTe inséré dans un empilement vertical incluant un port de la ligne métallique RF d'entrée et un port de la ligne métallique RF de sortie. Lorsque le PCM est à l'état amorphe, aucun signal électrique RF ne passe entre la ligne d'entrée et la ligne de sortie. Lorsque le PCM est à l'état cristallin, un signal électrique RF peut être transmis entre la ligne d'entrée et la ligne de sortie. Le changement d'état du PCM est obtenu en faisant passer une impulsion de courant entre la ligne d'entrée et la ligne de sortie directement au travers du ou des vias de PCM.

Dans cette structure, un chauffage direct du PCM est réalisé. Du fait que la portion de PCM est fine (épaisseur inférieure à quelques centaines de nanomètres) et insérée entre les lignes d'entrées et les lignes de sorties, la distance entre la ligne d'entrée et la ligne de sortie est faible, pénalisant ainsi l'isolation électrique entre ces lignes lorsque le commutateur est à l'état bloqué. De plus, le courant de chauffage du PCM passe par les ports d'entrée et de sortie RF du commutateur, pouvant créer à terme une usure de ces ports et de ce fait, modifier la qualité de la transmission RF dans ce commutateur.

Le document M. Wang et al., "Directly heated four-terminal phase change switches," Proc. IEEE MTT-S Int. Microw. Symp., Tampa, FL, USA, Jun. 2014, pp. 1-4, décrit un commutateur RF dans lequel le PCM est inséré dans le même plan horizontal que les lignes métalliques RF d'entrée et de sortie. Le changement de phase du PCM est obtenu par chauffage direct en faisant passer une impulsion de courant orthogonalement à la direction des lignes RF, directement au travers du PCM, au moyen d'électrodes de commande dédiées situées au-dessus et en-dessous du PCM.

Dans cette structure, l'épaisseur de la portion de PCM est très inférieure à sa largeur. Ce rapport entre l'épaisseur et la largeur de la portion de PCM n'est pas favorable à un changement de phase uniforme et complet vers l'état cristallin ou vers l'état amorphe dans toute la portion de PCM car la surface de PCM qui est traversée orthogonalement par le courant est trop importante par rapport à son épaisseur. Ce changement de phase non uniforme du PCM résulte en une augmentation de la résistance du commutateur à l'état passant et une diminution de l'isolation du commutateur à l'état bloqué. De plus, cette structure a pour inconvénient de nécessiter l'ajout de plots, dans des niveaux autres que celui où se trouve le PCM, dédiés au changement d'état du PCM, augmentant ainsi l'encombrement du commutateur.

Le document N. El-Hinnawy et al. (2013a) «A Four-Terminal, Inline, Chalcogenide Phase-Change RF Switch Using an Independent Resistive Heater for Thermal Actuation», Electron Device Letters, IEEE, Volume: 34, Issue: 10, pp. 1313-1315, décrit un commutateur RF dans lequel le PCM est inséré dans le même plan horizontal que la ligne métallique RF d'entrée et la ligne métallique RF de sortie. Le changement de phase est ici obtenu en faisant passer un courant dans une résistance couche mince, appelé « heater » ou « radiateur », placée sous le PCM et isolée électriquement du PCM par un matériau diélectrique. Lors du passage du courant dans le « heater », celui-ci va chauffer par effet joule et, indirectement, la radiation thermique produite par ce « heater » va changer l'état du PCM.

L'avantage de cette structure est que la zone de radiation thermique est définie par la taille du « heater » et non pas par la taille de la portion de PCM. Ainsi, il est plus aisé d'homogénéiser le changement de phase de l'ensemble du PCM.

Par contre, ce « heater », qui forme une structure de chauffage indirect du PCM, a pour inconvénient d'augmenter la consommation d'énergie nécessaire au changement d'état du PCM, en particulier pour le passage de l'état cristallin à l'état amorphe pour lequel la température à atteindre doit être élevée. Un autre inconvénient de cette structure est la destruction rapide du « heater » du fait que le passage de l'état cristallin à amorphe du PCM nécessite une température très élevée impliquant des densités de courant difficilement compatibles avec ce « heater » qui correspond à une résistance à couche mince.

Le document US2008/007995 divulgue une structure ou un chauffage direct du PCM est réalisé.

## EXPOSÉ DE L'INVENTION

Un but de la présente invention est de proposer un commutateur formant au moins un interrupteur à matériau à changement de phase, ou PCM, et :

- intégrant une structure de chauffage direct, c'est-à-dire dans lequel un courant de chauffage traverse directement le PCM, sans dispositif de type radiateur à proximité du PCM,
- permettant l'obtention d'une élévation en température du PCM qui soit homogène dans tout le PCM,
- n'impactant pas le chemin de transmission des signaux RF à travers le commutateur lorsque celui-ci à l'état passant,
- permettant l'obtention d'une bonne isolation électrique entre les lignes d'entrée et de sortie du commutateur lorsque celui-ci est à l'état bloqué,
- ne nécessitant pas l'ajout de plots dédiés au passage d'un courant de chauffage pour le changement d'état du PCM,
- dont l'état soit facilement programmable.

Pour cela, la présente invention propose un commutateur comprenant au moins une portion de PCM, apte à être dans un état passant ou bloqué en fonction de l'état, amorphe ou cristallin, du PCM qui est apte à changer d'état lorsqu'il est soumis à un chauffage,

dans lequel la portion de PCM est continue et de forme allongée telle qu'une entrée et une sortie du commutateur soient reliées respectivement à deux extrémités de la portion de PCM qui sont espacées l'une de l'autre d'une distance correspondant à la plus grande dimension de la portion de PCM,

et comportant un dispositif de commande de l'état du commutateur apte à faire circuler des courants de chauffage à travers la portion de PCM, sensiblement perpendiculairement à la plus grande dimension de la portion de PCM, depuis au moins deux points d'entrée, espacés l'un de l'autre et espacés des extrémités de la portion de PCM, vers au moins deux points de sortie espacés l'un de l'autre et espacés des extrémités de la portion de PCM.

Dans ce commutateur, les courants de chauffage traversent directement la ou les portions de PCM, évitant ainsi l'utilisation d'un dispositif de chauffage indirect du PCM qui augmente la consommation d'énergie nécessaire au changement d'état du PCM et dont la durée de vie est réduite en raison des courants de chauffage importants nécessaires pour atteindre les températures requises pour le chauffage du PCM.

De plus, un chauffage homogène du PCM est obtenu grâce au fait que plusieurs courants de chauffage sont envoyés en différents points de la portion de PCM. Chaque courant de chauffage réalise donc le chauffage d'une partie de la portion de PCM. L'élévation de température obtenue dans le PCM est donc homogène dans l'ensemble de la portion de PCM. Cette homogénéité de chauffage de la portion de PCM est également obtenue grâce au fait que dans ce commutateur, il n'est pas nécessaire de réaliser la portion de PCM telle que son épaisseur soit très inférieure à sa largeur. Cette homogénéité de l'état, amorphe ou cristallin, du PCM permet au commutateur d'avoir une très faible résistance à l'état passant et une importante isolation à l'état bloqué.

Les courants de chauffage sont destinés à traverser la portion de PCM sensiblement perpendiculairement à sa plus grande dimension. Ainsi, du fait que les signaux RF sont destinés à traverser la portion de PCM (lorsque celle-ci est à l'état passant) parallèlement à cette plus grande dimension, depuis l'entrée du commutateur reliée à une première extrémité de la portion de PCM jusque vers la sortie du commutateur reliée à une deuxième extrémité de la portion de PCM, le chemin de transmission des signaux RF à travers le commutateur, lorsque celui-ci est à l'état passant, n'est pas impacté par les courants de chauffage. De plus, les courants de chauffage ne passent pas par les extrémités de la portion de PCM, et ne dégradent donc pas les ports d'entrée et de sortie RF du commutateur.

En outre, du fait que la distance séparant l'entrée et la sortie du commutateur correspond à la plus grande dimension de la portion de PCM, l'isolation électrique entre l'entrée et la sortie du commutateur est bonne lorsque le commutateur est à l'état bloqué.

La structure de ce commutateur a également pour avantage de ne pas modifier l'impédance d'entrée du commutateur lorsque celui-ci est à l'état bloqué, et ne nécessite pas l'ajout de plots dédiés au passage d'un courant de chauffage pour le changement d'état du PCM.

La portion de PCM est qualifiée de « continue », c'est-à-dire qu'elle ne correspond pas à plusieurs portions de PCM espacées les unes des autres et alignées les unes des autres parallèlement à la plus grande dimension de la portion de PCM.

En outre, la portion de PCM est qualifiée de « allongée » car elle comporte une dimension appelée longueur, parallèle à un axe, supérieure aux autres dimensions de la portion de PCM (par exemple la largeur, l'épaisseur, etc.) selon les autres axes.

Le dispositif de commande peut comporter une pluralité de composants électroniques formant des premières sources de courant chacune apte à injecter un des courants de chauffage dans la portion de PCM depuis l'un des points d'entrée, et des deuxièmes sources de courant chacune apte à extraire l'un des courants de chauffage depuis l'un des points de sortie.

Dans ce cas, les premières et deuxièmes sources de courant formées par les composants électroniques du dispositif de commande peuvent être aptes à être commandées simultanément par un même signal de commande CTR. Avec un tel dispositif de commande, la programmation de l'état du commutateur peut être réalisée aisément à partir d'un seul signal de commande binaire.

Chacune des premières sources de courant peut comporter au moins un transistor MOS comportant l'une de ses électrodes de source et de drain reliée à l'un des points d'entrée et l'autre de ses électrodes de source et de drain à un potentiel électrique d'alimentation, et dont la grille est apte à recevoir le signal de commande CTR.

Chacune des premières sources de courant peut comporter au moins un autre transistor MOS interposé entre ladite autre électrode de source et de drain du précédent transistor MOS et le potentiel électrique d'alimentation, et dont la grille est reliée au potentiel électrique d'alimentation.

Dans ce cas, chacune des deuxièmes sources de courant peut comporter au moins plusieurs transistors MOS montés en miroir de courant, au moins l'un desdits transistors MOS comportant sa grille apte à recevoir le signal de commande CTR.

Dans cette configuration, le miroir de courant peut comporter une première branche dans laquelle circule un courant de référence dont la valeur est imposée, et une deuxième branche dans laquelle le courant circulant dans la première branche est recopié. Le point de sortie peut être relié à la deuxième branche. Chacune des première et deuxième branches peut comporter au moins un transistor MOS commandé par le signal de commande CTR.

De plus, chacune des deuxièmes sources de courant peut comporter en outre au moins un élément résistif couplé au miroir de courant et apte à former une résistance ayant une première ou une deuxième valeurs, différentes l'une de l'autre et telles que la valeur du courant de chauffage extrait par la deuxième source de courant soit adaptée en fonction de l'état du commutateur destiné à être commandé par le dispositif de commande. Ainsi, les valeurs des courants de chauffage peuvent être adaptées en fonction de l'état dans lequel le PCM est destiné à basculer. L'élément résistif peut être relié à la première branche de référence du miroir de courant.

En variante, les deuxièmes sources de courant peuvent être formées par au moins un convertisseur numérique - analogique. Le convertisseur numérique - analogique peut être tel que le signal d'entrée du convertisseur corresponde à une tension ou à un courant.

De manière avantageuse, la portion de PCM peut avoir une forme parallélépipédique rectangle de longueur supérieure à sa largeur et à son épaisseur. La longueur correspond à la plus grande dimension de la portion de PCM.

Dans ce cas, les points d'entrée et de sortie peuvent être disposés sur des faces latérales de la portion de PCM espacées l'une de l'autre d'une distance correspondant à sa largeur. Cette configuration est avantageuse car lorsque le commutateur est réalisé au sein d'un circuit intégré, les entrée et sortie du commutateur peuvent être formées par des portions d'un niveau d'interconnexions métalliques dans lequel se trouve la portion de PCM, ces portions métalliques pouvant être disposées contre la portion de PCM. De plus, cela évite la présence de capacités électriques telles que celles rencontrées dans les structures de chauffage de l'art antérieur réalisant un chauffage direct du PCM à travers son épaisseur.

Le commutateur peut comporter plusieurs portions de PCM disposées sensiblement parallèlement les unes à côté des autres, le dispositif de commande pouvant être apte à faire circuler des courants de chauffage à travers chacune des portions de PCM, sensiblement perpendiculairement à la plus grande dimension de chacune des portions de PCM, depuis au moins deux points d'entrée, espacés l'un de l'autre et espacés des extrémités de chacune des portions de PCM, vers au moins deux points de sortie espacés l'un de l'autre et espacés des extrémités de chacune des portions de PCM. Cette répartition de la quantité totale de PCM du commutateur en plusieurs portions distinctes, espacées (géométriquement et thermiquement) les unes des autres, facilite le chauffage du PCM et permet d'homogénéiser le chauffage du PCM, contrairement à une unique portion de PCM comportant une quantité équivalente de PCM.

Le commutateur peut comporter en outre, lorsque le dispositif de commande comporte la pluralité de composants électroniques formant des premières et deuxièmes sources de courant, un dispositif couplé aux extrémités de la ou des portions de PCM et apte à compenser des capacités parasites de transistors MOS destinés à activer ou désactiver les premières et deuxièmes sources de courant. L'ajout d'un tel dispositif compensant les capacités parasites des transistors MOS destinés à activer ou désactiver les premières et deuxièmes sources de courant permet de réduire les contraintes pesant sur le dimensionnement des transistors, afin d'éviter la présence de fortes capacités parasites dans ces transistors MOS.

Lorsque le dispositif de commande comporte la pluralité de composants électroniques formant des premières et deuxièmes sources de courant, lesdits composants électroniques peuvent comporter des zones actives formées dans au moins une couche de semi-conducteur, et la portion de PCM peut être disposée au sein d'un niveau d'interconnexions métalliques se trouvant au-dessus de la couche de semi-conducteur et espacée de la couche de semi-conducteur par au moins un diélectrique intercouche. Les composants électroniques peuvent être dans ce cas reliés à la portion de PCM par des vias conducteurs traversant le diélectrique intercouche et éventuellement un ou plusieurs autre(s) niveau(x) d'interconnexions métalliques disposé(s) entre la couche de semi-conducteur et le niveau d'interconnexions métalliques dans lequel est formée la portion de PCM.

L'invention concerne également un dispositif d'adaptation d'une ligne de transmission, comprenant au moins :

- une première portion de matériau électriquement conducteur comprenant une première extrémité destinée à être reliée à la ligne de transmission et une deuxième extrémité reliée à au moins une deuxième portion de matériau électriquement conducteur destinée à être reliée à un potentiel de référence,
- une pluralité de commutateurs tels que décrits ci-dessus, les extrémités de la ou des portions de PCM de chacun des commutateurs étant couplées aux première et deuxième portions de matériau électriquement conducteur à différentes distances par rapport à la première extrémité de la première portion de matériau électriquement conducteur telles que la longueur d'adaptation du dispositif soit apte à être définie par la distance entre la première extrémité de la première portion de matériau électriquement conducteur et le commutateur à l'état passant le plus proche de la première extrémité de la première portion de matériau électriquement conducteur.

Par rapport à un dispositif d'adaptation de ligne de transmission de longueur variable faisant appel à des transistors pour définir la longueur d'adaptation, l'utilisation de commutateurs à base de PCM tels que définis ci-dessus évite le problème lié au dimensionnement des transistors, qui doivent être de petite taille afin d'éviter la formation de capacités parasites trop fortes, mais qui a pour conséquence une augmentation de la résistance à l'état passant du dispositif.

L'invention porte également sur un dispositif déphaseur d'une ligne de transmission différentielle, comprenant au moins :

- plusieurs premières lignes à retard destinées à être couplées à une première portion électriquement conductrice de la ligne de transmission différentielle ;
- plusieurs deuxièmes lignes à retard destinées à être couplées à une deuxième portion électriquement conductrice de la ligne de transmission différentielle ;
- plusieurs commutateurs tels que décrit ci-dessus, les extrémités de la ou des portions de PCM de chacun des commutateurs étant couplées à l'une des premières lignes à retard et à l'une des deuxièmes lignes à retard telles que lesdites première et deuxième lignes à retard soient aptes à être reliées électriquement l'une à l'autre lorsque le commutateur est à l'état passant et aptes à être reliées à un potentiel électrique de référence lorsque le commutateur est à l'état bloqué.

Par rapport à un dispositif déphaseur utilisant des transistors pour connecter les lignes à retard entre elles ou à la masse, l'utilisation de commutateurs à base de PCM tels que définis ci-dessus permet de réduire la résistance à l'état passant (Ron) du dispositif ainsi que les capacités parasites (Coff) formées au sein du dispositif déphaseur, et donc d'améliorer le rapport Ron/Coff du dispositif déphaseur.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente schématiquement un commutateur, objet de la présente invention, selon un mode de réalisation particulier;
- la figure 2 représente schématiquement une portion de PCM d'un commutateur, objet de la présente invention, selon un mode de réalisation particulier ;
- la figure 3 représente schématiquement une partie des éléments électroniques d'un circuit de commande d'un commutateur, objet de la présente invention, selon un premier mode de réalisation particulier ;

- la figure 4 représente schématiquement un circuit électrique équivalent d'une portion de PCM à l'état amorphe couplée à un circuit de commande du commutateur, objet de la présente invention ;
- la figure 5 représente schématiquement un circuit électrique équivalent d'une portion de PCM à l'état amorphe couplée à un circuit de commande du commutateur, objet de la présente invention, ainsi que d'un substrat sur lequel se trouve cette portion de PCM ;
- la figure 6 représente schématiquement les différences capacités parasites reliées à la portion de PCM et qui sont liées aux transistors du circuit de commande du commutateur, objet de la présente invention ;
- la figure 7 représente schématiquement un circuit électrique équivalent de la portion de PCM du commutateur, objet de la présente invention, couplée aux sources de courant formées par le circuit de commande lorsque le PCM est à l'état cristallin ;
- la figure 8 représente schématiquement un commutateur, objet de la présente invention, comportant un dispositif de compensation des capacités parasites de transistors du dispositif de commande du commutateur ;
- la figure 9 représente schématiquement un dispositif d'adaptation d'une ligne de transmission, objet de la présente invention, comprenant une pluralité de commutateurs également objets de la présente invention ;
- les figures 10 et 11 représentent schématiquement un dispositif déphaseur d'une ligne de transmission différentielle, objet de la présente invention, comprenant une pluralité de commutateurs également objets de la présente invention ;
- les figures 12 et 13 représentent schématiquement une partie des éléments électroniques d'un circuit de commande d'un commutateur, objet de la présente invention, selon différentes variantes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

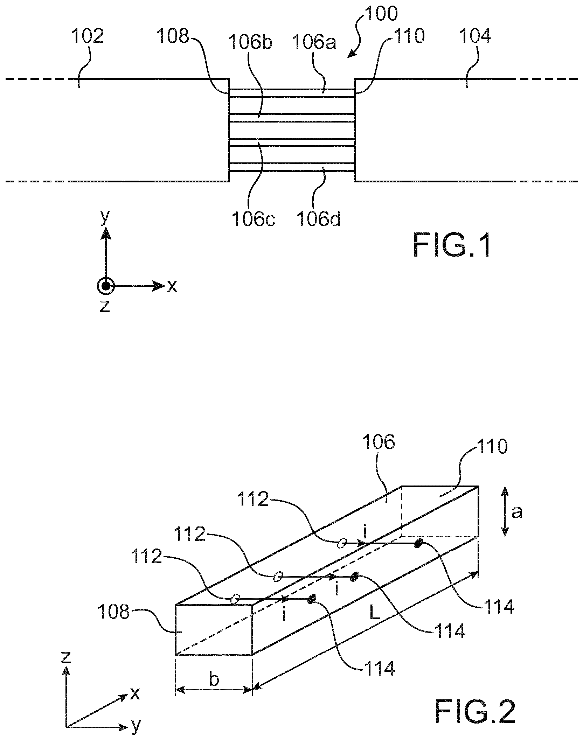

On se réfère tout d'abord à la figure 1 qui représente schématiquement un commutateur 100 selon un mode de réalisation particulier.

Le commutateur 100 est ici interposé entre deux lignes métalliques 102, 104. La ligne 102 correspond à la ligne d'entrée de signaux RF dans le commutateur 100 et forme l'entrée du commutateur 100. La ligne 104 correspond à la ligne de sortie de ces signaux RF et forme la sortie du commutateur 100.

Dans ce mode de réalisation particulier, le commutateur 100 forme un interrupteur permettant ou non, selon son état passant ou bloqué, le passage des signaux RF depuis la ligne 102 vers la ligne 104. En variante, le commutateur 100 pourrait former plusieurs interrupteurs aptes à router, ou diriger, des signaux vers différents chemins de conduction.

Le commutateur 100 comporte plusieurs portions de PCM 106 (quatre portions sur la figure 1, référencées 106a - 106d) ayant chacune une forme sensiblement allongée, c'est-à-dire ayant chacune une dimension (longueur) supérieure à ses autres dimensions (par exemple largeur et épaisseur). La plus grande dimension de chacune des portions de PCM 106 est sensiblement parallèle à la direction de déplacement des signaux RF destinés à traverser l'interrupteur 100 depuis la ligne 102 jusque dans la ligne 104. En outre, chacune des portions de PCM 106 est continue, contrairement à plusieurs portions de PCM qui seraient espacées les unes des autres.

Le PCM des portions 106 est par exemple du GeTe, ou tout autre matériau à changement de phase adapté, comportant par exemple au moins l'un des matériaux suivants : $Ge_2Sb_2Te_5$, GeTeN, GeTeC, GeTeB.

L'une des portions de PCM 106 est représentée plus en détails sur la figure 2. La portion 106 a ici une forme longiligne s'étendant selon la direction de l'axe X, c'est-à-dire comporte sa plus grande dimension L, appelée longueur, parallèle à cet axe X. Les signaux RF sont destinés à traverser la portion 106 depuis une première extrémité 108 reliée à la ligne 102, jusqu'à une deuxième extrémité 110 de la portion 106 reliée à la ligne 104, ces deux extrémités 108, 110 étant séparées l'une de l'autre d'une distance égale à la longueur L.

Sur l'exemple de la figure 2, la portion 106 comporte une section, dans un plan perpendiculaire à sa longueur L, de forme sensiblement rectangulaire et de dimension a x b, avec a correspondant à l'épaisseur de la portion 106 et b correspondant à sa largeur. En considérant les différentes dimensions de la portion 106, les relations suivantes sont vérifiées : $L > a$ et $L > b$. De plus, de manière avantageuse, le rapport L/b est supérieur ou égal à environ 30.

De manière générale, chaque portion 106 peut comporter une section, dans un plan perpendiculaire à sa longueur L, d'une forme autre que rectangulaire, les dimensions de cette section (côtés, diamètre, etc.) étant inférieures à la longueur L de la portion 106.

Le changement de phase du matériau de chaque portion 106 est commandé par un circuit de commande 116 (non représenté sur la figure 2) formant plusieurs sources de courant de chauffage destinées à appliquer, en plusieurs points d'entrée de chacune des portions 106, des courants électriques qui traversent chacune des portions 106 depuis ces points d'entrée et ressortent de chacune des portions 106 au niveau de plusieurs points de sortie. Le circuit de commande 116 forment également des sources de courant reliées à ces points de sortie et permettant de « tirer », ou d'extraire, les courants de chauffage depuis ces points de sortie jusque hors des portions 106. Sur l'exemple de la figure 2, il est représenté symboliquement que la portion 106 est traversée par des courants de chauffage « i » depuis trois points d'entrée 112, ces courants de chauffage i sortant de la portion 106 au niveau de trois points de sortie 114 se trouvant chacun sensiblement en regard d'un des points d'entrée 112.

Les points d'entrée et de sortie 112, 114 des courants de chauffage traversant chacune des portions 106 sont définis, c'est-à-dire localisés sur la portion 106, de préférence tels que les courants de chauffage traversent la portion 106 parallèlement à sa largeur b. Toutefois, il est possible qu'en variante, ces points d'entrée et de sortie 112, 114 soient disposés tels que les courants de chauffage destinés à changer l'état du PCM de la portion 106 traversent la portion 106 parallèlement à son épaisseur a.

Le circuit de commande 116 forme un ensemble de sources de courant de chauffage programmables qui viennent localement injecter des courants de chauffage à travers la largeur des portions 106, et extraire ces courants de chauffage.

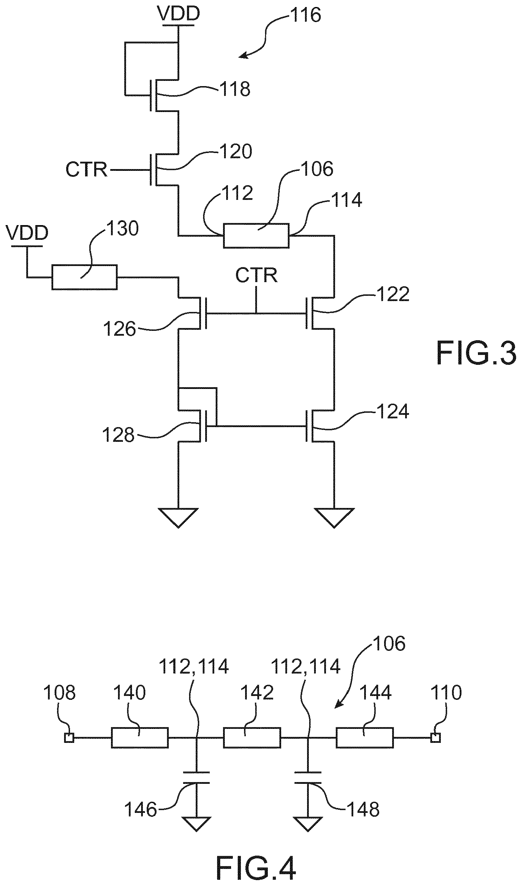

La figure 3 représente schématiquement une partie des éléments électroniques du circuit de commande 116 selon un exemple de réalisation particulier, les éléments électroniques représentés permettant l'envoi d'un courant de chauffage à travers la portion 106 depuis l'un des points d'entrée 112 et l'extraction de ce courant de chauffage depuis l'un des points de sortie 114.

Ces éléments électroniques incluent un premier transistor MOS 118 dont la grille est reliée à l'une des électrodes de source et de drain (au drain dans le cas d'un transistor 118 de type N tel que représenté sur la figure 3) elle-même reliée à un potentiel électrique d'alimentation $V_{DD}$. L'autre électrode de source et de drain du premier transistor 118 est reliée à l'une des électrodes de source et de drain d'un deuxième transistor MOS 120 (drain dans le cas d'un transistor 120 de type N) dont l'autre électrode de source et de drain est reliée au point d'entrée 112. Un signal de commande CTR est destiné à être appliqué sur la grille du deuxième transistor 120.

Les premier et deuxième transistors 118, 120 forment une première source de courant commandé apte à injecter un courant de chauffage « i » dans le point d'entrée 112 lorsque le signal CTR rend passant le deuxième transistor 120. Le premier transistor 118 forme un élément isolant le deuxième transistor 120 vis-à-vis du potentiel $V_{DD}$ lorsque le deuxième transistor 120 est bloqué.

Les autres éléments électroniques du circuit de commande 116 visibles sur la figure 3 forment une deuxième source de courant commandé permettant d'extraire, ou « tirer », le courant de chauffage injecté dans le point d'entrée 112, depuis le point de sortie 114.

Ces éléments électroniques incluent un troisième transistor MOS 122 dont l'une des électrodes de source et de drain (drain dans le cas d'un transistor de type N) est reliée au point de sortie 114. Le signal de commande CTR est destiné à être appliqué sur la grille du troisième transistor 122. L'autre électrode de source et de drain du troisième transistor 122 est reliée à l'une des électrodes de source et de drain (drain dans le cas d'un transistor de type N) d'un quatrième transistor MOS 124 dont l'autre électrode de source et de drain est reliée à la masse.

Les autres éléments électroniques formant la deuxième source de courant incluent également des cinquième et sixième transistors 126, 128 couplés aux troisième et quatrième transistors 122, 124 tels que ces quatre transistors 122 - 128 forment un miroir de courant. Ainsi, le signal de commande CTR est également destiné à être appliqué sur la grille du cinquième transistor 126. De plus, la grille du sixième transistor 128 est reliée à celle du quatrième transistor 124 ainsi qu'à l'électrode de source et de drain du sixième transistor 128 qui est reliée au cinquième transistor 126.

L'une des électrodes de source et de drain du cinquième transistor 126 (celle qui n'est pas reliée au sixième transistor 128, et qui correspond au drain dans le cas d'un transistor de type N) est reliée à un élément résistif 130 qui est apte à prendre deux valeurs de résistance électrique différentes, appelées R1 et R2, en fonction d'un signal de commande appliqué sur cet élément. Cet élément résistif variable 130 est également relié au potentiel électrique d'alimentation $V_{DD}$.

Dans la configuration représentée sur la figure 3, le miroir de courant comporte une première branche formée par l'élément résistif 130 et les cinquième et sixième transistors 126, 128 dans laquelle circule un courant de référence dont la valeur est imposée par la valeur de résistance présentée par l'élément résistif 130 ainsi que par la valeur de la tension de saturation $V_{Dsat}$ du cinquième transistor 126 et la valeur de la tension grille - source $V_{GS}$ du sixième transistor 128. Le miroir de courant comporte également une deuxième branche formée par les troisième et quatrième transistors 122, 124 dans laquelle le courant circulant dans la première branche est recopié, forçant ainsi l'extraction du courant de chauffage provenant de la portion 106.

Bien que non représentés, le circuit de commande 116 inclut des éléments électroniques similaires aux éléments 118 à 130 décrits ci-dessus pour former les autres sources de courant de chauffage destinées à chauffer les autres parties de la portion 106 ainsi que les autres portions 106. Par exemple, en prenant l'exemple de la portion 106 représentée sur la figure 2 dans laquelle trois courants de chauffage « i » sont injectés depuis trois points d'entrée 112, les éléments électroniques du circuit de commande 116 réalisant le chauffage de cette portion 106 incluent trois ensembles d'éléments électroniques chacun similaire à celui correspondant aux éléments électroniques 118 à 130 représentés sur la figure 3.

Le nombre de sources de courant de chauffage formées par le circuit de commande 116 pour chaque portion 106, ainsi que les distances entre les points d'entrée 112, entre les points de sortie 114, entre les points d'entrée et de sortie 112, 114 et les extrémités 108, 110 de la portion 106, dépendent notamment de la vitesse avec laquelle la chaleur se propage dans le PCM, c'est-à-dire de la résistance thermique associée à ce PCM, ainsi que de sa capacité thermique. Par exemple, pour une portion 106 de GeTe de forme sensiblement parallélépipédique rectangle telle que représentée sur la figure 2, et ayant une section (surface des extrémités 108, 110) comprise entre environ 100 nm$^2$ et 10000 nm$^2$, le nombre de sources de courant de chauffage est choisi de manière à avoir des points d'entrée 112 espacés les uns des autres d'une distance égale à environ 10 μm, ce qui permet d'obtenir un changement de phase du PCM de la portion 106 après une durée de chauffage en adéquation avec les spécifications temporelles attendues pour un changement d'état d'un commutateur utilisé en tant que switch d'antenne RF. Cette distance entre deux points d'entrée 112 voisins est similaire à celle entre deux points de sortie 114 voisins. La distance entre les extrémités 108, 110 de la portion 106 et les points d'entrée et de sortie 112, 114 les plus proches de ces extrémités 108, 110 est par exemple égale à la moitié de cette distance d'espacement entre deux points d'entrée 112 voisins et entre deux points de sortie 114 voisins, ici par exemple environ 5 μm.

Pour réaliser le passage de l'état bloqué à l'état passant du commutateur 100, qui correspond à un passage de l'état amorphe à l'état cristallin du PCM des portions 106 du commutateur 100, le signal de commande CTR passe à l'état haut (V$_{DD}$) afin de rendre passants les transistors 120, 122 et 126. Le courant de chauffage injecté dans la portion 106 par chaque première source de courant formée par le circuit 116 traverse la largeur b de la portion 106, cette largeur b étant par exemple de l'ordre de quelques centaine de nanomètres. Au début de ce changement d'état, en raison de la faible distance (moins de 1 μm) entre le point d'entrée 112 et le point de sortie 116 se trouvant en face, et de la distance importante avec le ou les autres points d'entrée 112 voisins (par exemple environ 10 μm), la première source de courant formée par les premier et deuxième transistors 118, 120 voit, entre le point d'entrée 112 et le point de sortie 116, une impédance par exemple comprise entre environ 20 kΩ et 100 kΩ qui est inférieure à celle entre ce point d'entrée 112 et un point d'entrée 112 voisin qui est par exemple supérieure à environ 1 MΩ. Par conséquent, le courant injecté dans le point d'entrée 112 circule depuis ce point d'entrée 112 vers le point de sortie 114 se trouvant en face de ce point d'entrée 112. Ce courant circulant dans le PCM créé ainsi un auto-échauffement du PCM, cet échauffement étant d'autant plus important que la résistance formée par le PCM est élevée.

Les éléments électroniques du circuit de commande 116 sont dimensionnés tels que lors du passage de l'état bloqué vers l'état passant du commutateur 100, le courant de chauffage, appelé «I1» dans ce cas, traversant la portion 106 entraîne, pour une tension d'alimentation V$_{DD}$ de l'ordre de 2V, une chute de tension entre le point d'entrée 112 et le point de sortie 114 inférieure à environ 1V pour des transistors comprenant des zones actives de silicium par exemple réalisés en technologie 130 nm et de type PD-SOI (silicium sur isolant partiellement déserté) sur un substrat de silicium HR (haute résistivité, par exemple de l'ordre de 1kΩ.cm). De plus, la résistance variable 130 a, lors de ce changement d'état, la valeur R1 qui peut être choisie telle que :

R1 x I1 + V$_{Dsat}$(126) + V$_{GS}$(128) = V$_{DD}$, avec V$_{Dsat}$(126) la tension de saturation du cinquième transistor 126, et V$_{GS}$(128) la tension entre la grille et la source du sixième transistor 128.

Ce chauffage du PCM entraîne, à partir de la température de basculement du PCM, son changement de phase correspondant au passage de l'état amorphe à l'état cristallin. Dès le changement de phase obtenu, les sources de courant formées par le circuit 116 sont coupées (via le passage à l'état bas (GND) du signal de commande CTR, bloquant les transistors 120, 122 et 126) afin d'arrêter la circulation des courants de chauffage dans les portions 106.

La détection du passage de l'état amorphe à l'état cristallin du PCM des portions 106 peut être réalisée de différentes manières, par exemple en mesurant la tension aux bornes des portions 106 (tension proche de 0 V lorsque les portions 106 sont passantes), ou bien en mesurant la température ou l'impédance dans les portions 106.

Pour réaliser le passage de l'état passant à l'état bloqué du commutateur 100, qui correspond à un passage de l'état cristallin à l'état amorphe du PCM des portions 106 du commutateur 100, le signal de commande CTR passe à l'état haut afin de rendre passants les transistors 120, 122 et 126. Le courant de chauffage injecté dans la portion 106 par chaque source de courant formée par le circuit de commande 116 traverse la largeur b de la portion 106. Comme lors du passage de l'état bloqué à l'état passant précédemment décrit, en raison de la faible distance (moins de 1 μm) entre le point d'entrée 112 et le point de sortie 116 se trouvant en face, et de la distance importante avec le ou les autres points d'entrée 112 voisins (par exemple environ 10 μm), la première source de courant formée par les premier et deuxième transistors 118, 120 voit, entre le point d'entrée 112 et le point de sortie 116, une impédance par exemple comprise entre environ 1 mΩ et 10 mΩ, qui est inférieure à celle entre ce point d'entrée 112 et un point d'entrée voisin qui est par exemple comprise entre environ 20 mΩ et 100 mΩ. Par conséquent, le courant injecté dans le point d'entrée 112 circule depuis ce point d'entrée 112 vers le point de sortie 116 se trouvant en face de ce point d'entrée 112. Ce courant circulant dans le PCM créé ainsi un auto-échauffement du PCM, cet échauffement étant d'autant plus important que le courant est élevé.

Les éléments électroniques du circuit de commande 116 sont dimensionnés tels que lors du passage de l'état passant vers l'état bloqué du commutateur 100, le courant de chauffage, appelé « I2 » dans ce cas », traversant la portion 106 entraîne, pour une tension d'alimentation $V_{DD}$ de l'ordre de 2V, une chute de tension entre le point d'entrée 112 et le point de sortie 114 inférieure à environ 1V pour des transistors tels que décrits précédemment. De plus, la résistance variable 130 a, lors de ce changement d'état, la valeur R2 qui peut être choisie telle que :

$$R2 \times I2 + V_{Dsat}(126) + V_{GS}(128) = V_{DD}.$$

Ce chauffage du PCM entraîne, à partir de la température de basculement du PCM, son changement de phase de l'état cristallin à l'état amorphe. Dès le changement de phase obtenu, les sources de courant formées par le circuit de commande 116 sont coupées (via le passage à l'état bas du signal de commande CTR, bloquant les transistors 120, 122 et 126) afin d'arrêter la circulation des courants de chauffage dans les portions 106.

Lorsque le PCM passe à l'état amorphe, la tension aux bornes de chacune des portions 106 va tendre vers $V_{DD}$, ce qui arrête le fonctionnement des sources de courant formées par le circuit de commande 116. La détection du passage de l'état cristallin à l'état amorphe du PCM des portions 106 peut être réalisée en mesurant la tension aux bornes des portions 106 (tension proche de $V_{DD}$ lorsque les portions 106 sont bloquées), ou bien en mesurant le courant fourni par les sources de courant.

La figure 4 représente schématiquement un circuit électrique équivalent d'une des portions 106 couplée aux sources de courant formées par le circuit de commande 116 lorsque le PCM est à l'état amorphe. L'exemple de la figure 4 correspond à une portion 106 destinée à être traversée par deux courants de chauffage depuis deux points d'entrée 112 jusque vers deux points de sortie 114.

Les résistances 140, 142 et 144 correspondent à différentes parties du PCM de la portion 106. Ainsi, la résistance 140 correspond au PCM se trouvant entre la première extrémité 108 et les premiers points d'entrée et de sortie 112, 114 auxquels le circuit de commande 116 est relié. La résistance 144 correspond au PCM se trouvant entre les deuxièmes points d'entrée et de sortie 112, 114 auxquels le circuit de commande 116 est relié et la deuxième extrémité 110. La résistance 142 est formée par le PCM se trouvant entre les premiers et deuxièmes points d'entrée et de sortie 112, 114. Ces résistances 140, 142 et 144 ont par exemple chacune une valeur de l'ordre de 1 MΩ.

Les capacités 146, 148, appelées Coff, correspondent chacune à la somme des capacités parasites formées par les transistors du circuit de commande 116 formant les sources de courant reliées aux points d'entrée et de sortie 112, 114, notamment les capacités drain-source et les capacités grille-source de ces transistors.

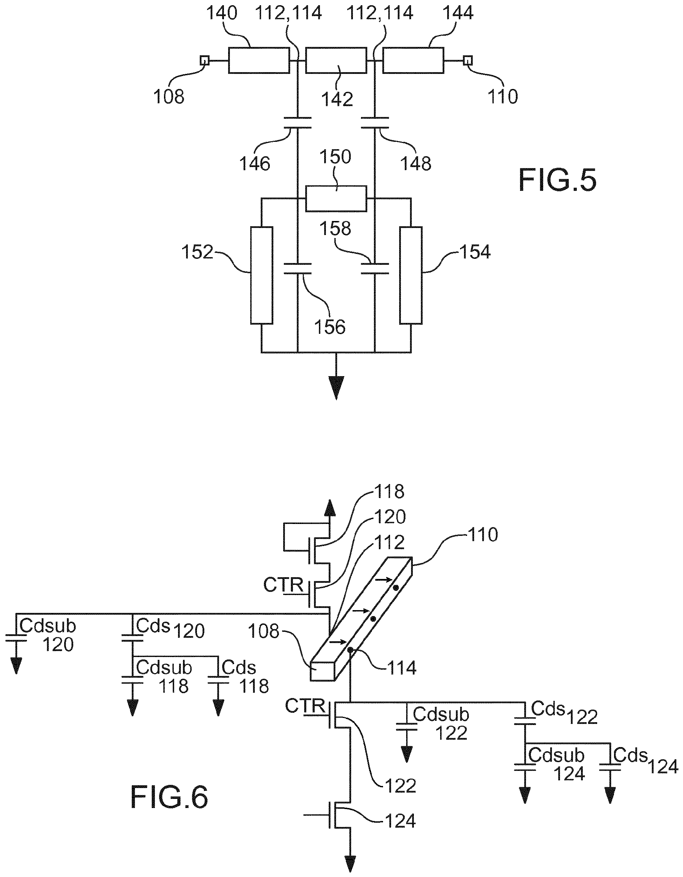

En tenant compte du substrat sur lequel les portions 106 sont réalisées, le circuit électrique équivalent de la figure 4 peut être modifié tel qu'il corresponde à celui de la figure 5. En considérant le substrat, trois résistances 150, 152 et 154 et deux capacités 156, 158 supplémentaires sont ajoutées dans ce schéma électrique équivalent.

L'impédance d'entrée Zin du circuit représenté sur la figure 5 (impédance vue entre la première extrémité 108 et la masse) est telle que :

$$Zin = \sum_{k=0}^{n} \left( Zk + \frac{1}{J.Coff} + \frac{RsubV}{(1 + \tau subV)} \right)$$

Avec Zk : résistances des différentes parties de PCM de la portion 106 (correspondant aux résistances référencées 140, 142 et 144 sur la figure 5) ;

RsubV : somme des résistances formées par les différentes parties du substrat (correspondant aux résistances référencées 152, 154 sur la figure 5) ;

$\tau subV = RsubV \times$ valeur de la somme des capacités 156 et 158.

Cette impédance d'entrée Zin a une valeur égale à plusieurs MΩ et le schéma électrique de la figure 5 peut être assimilé à un circuit ouvert lorsque le PCM est à l'état amorphe.

L'impédance de sortie Zout du circuit représenté sur la figure 5 (impédance vue entre la deuxième extrémité 110 et la masse) est telle que :

$$Zout = \sum_{k=n}^{0} \left( Zk + \frac{1}{J.Coff} + \frac{RsubV}{(1 + \tau subV)} \right)$$

La valeur de cette impédance de sortie est similaire à celle de l'impédance d'entrée Zin et le circuit formé est donc également assimilable à un circuit ouvert.

La valeur de l'impédance formée entre les extrémités 108, 110, appelée Ziso, est telle que :

$$Ziso = \sum_{k=0}^{n} \frac{Zk \times (\frac{1}{J.Coff} + Rsubk)}{Zk + Rsubk + \frac{1}{J.Coff}}$$

Rsubk : résistances formées par les différentes parties du substrat entre les différents ensembles de points d'entrée et de sortie (correspondant à la résistance référencée 150 sur la figure 5).

Ainsi, plus les valeurs de Rsubk et $1/j.Coff$ sont élevées, plus la valeur de l'impédance formée entre les extrémités 108, 110 est proche de la somme des résistances des différentes parties de PCM de la portion 106. Or, étant donné que la valeur de Rsubk est déterminée par la résistivité du substrat et est bien inférieure à environ 1 kΩ, il est judicieux d'avoir une valeur Coff très faible.

La figure 6 représente les différences capacités parasites reliées à la portion 106 et liées aux transistors du circuit de commande 116. Les capacités $Cdsub_{118}$, $Cdsub_{120}$, $Cdsub_{122}$ et $Cdsub_{124}$ correspondent aux capacités entre le substrat et le drain respectivement des transistors 118, 120, 122 et 124. Les capacités $Cds_{118}$, $Cds_{120}$, $Cds_{122}$ et $Cds_{124}$ correspondent aux capacités drain - source de chacun des transistors 118, 120, 122 et 124.

Après réduction, l'équation déterminant la valeur de 1/Coff en fonction de ces capacités parasites devient :

$$\frac{1}{Coff}$$

$$= \frac{(Cds120 + 1) \times (Cds122 + 1)}{(Cds120 + 1)x\big((Cds122 + 1) \times Cdsub122 + 1\big) + (Cds122 + 1) \times \big((Cds120 + 1) \times Cdsub120 + 1\big)}$$

Ainsi, les capacités parasites des transistors 118 et 124 n'ont pas d'impact sur la valeur de 1/Coff. Les transistors 120 et 122 sont réalisés de préférence telle que leurs capacités parasites permettent d'augmenter l'impédance entre la portion 108 et la masse, et ainsi réduire les pertes dans le commutateur 100.

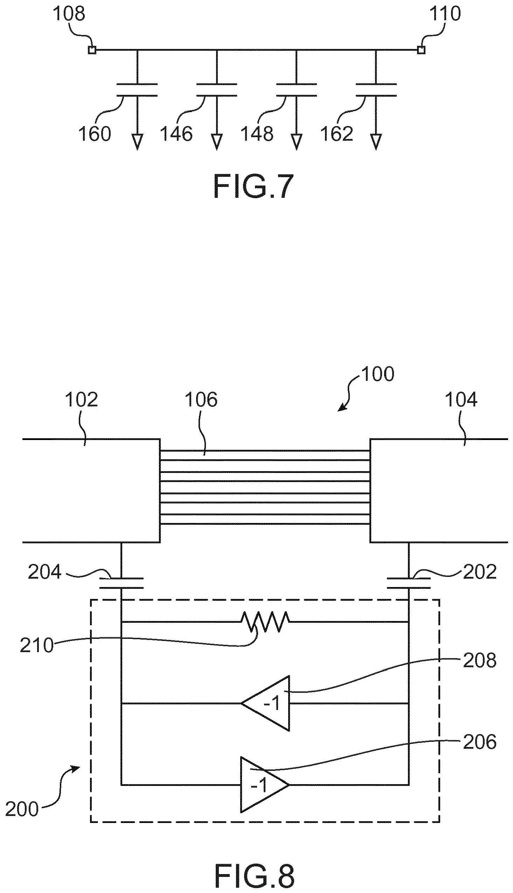

La figure 7 représente schématiquement un circuit électrique équivalent de la portion 106 couplée aux sources de courant formées par le circuit de commande 116 lorsque le PCM est à l'état cristallin, ou passant.

Contrairement aux circuits représentés sur les figures 4 et 5, le circuit équivalent de la figure 7 ne comporte pas de résistance électrique étant donné que le PCM est à l'état cristallin. Ainsi, ce circuit électrique équivalent comporte uniquement les capacités 146, 148 de valeurs Coff, ainsi que les capacités 160, 162 également de valeur Coff.

Pour la réalisation du commutateur 100 précédemment décrit, les éléments électroniques du circuit de commande 116 peuvent être réalisés dans la partie front-end du circuit intégré dont fait partie le commutateur 100. Les portions 106 de PCM peuvent être réalisées au sein d'un des niveaux d'interconnexions métalliques de la partie back-end du circuit. Les composants électroniques (notamment des transistors) du circuit de commande 116 sont dans ce cas reliés aux portions 106 de PCM par des vias conducteurs traversant le diélectrique intercouche et éventuellement un ou plusieurs autre(s) niveau(x) d'interconnexions métalliques disposé(s) entre la couche de semi-conducteur dans laquelle les composants électroniques sont fabriqués et le niveau d'interconnexions métalliques dans lequel est formée la portion 106 de PCM.

En variante du mode de réalisation particulier précédemment décrit, il est possible que le circuit de commande 116 comporte, à la place des transistors 122 -128 formant le miroir de courant, un convertisseur numérique - analogique en courant ou en tension, ou plus généralement tout moyen électronique permettant d'imposer la circulation d'un courant de chauffage à travers les portions 106 de PCM.

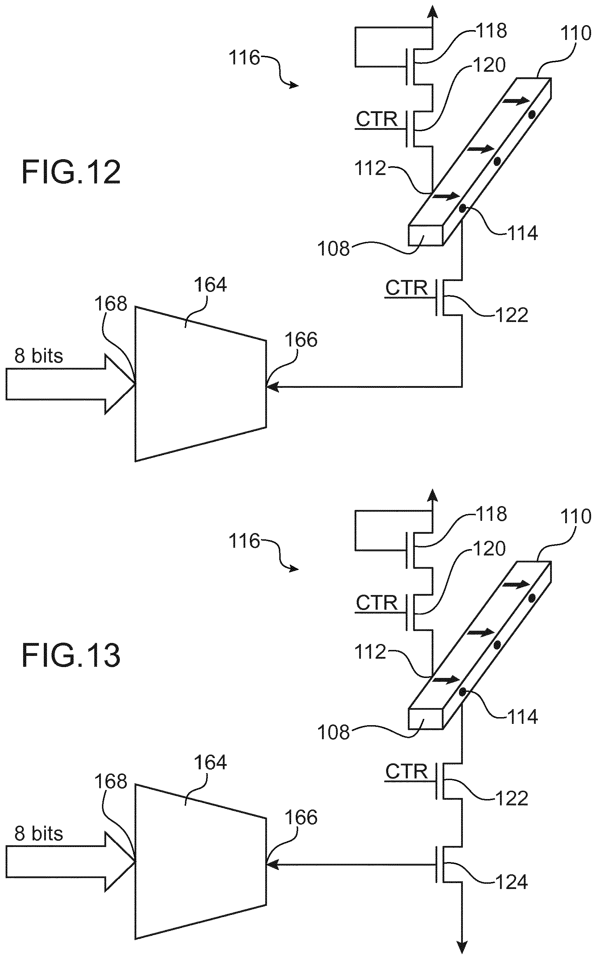

La figure 12 représente une telle variante dans laquelle le circuit commande 116 comporte, à la place du miroir de courant formé par les transistors 122, 124, 126 et 128 et de l'élément résistif 130, des convertisseurs numérique - analogique 164 en courant, chacun comportant une sortie 166 reliée à l'un des points de sortie 114 à travers le transistor MOS 122. Dans cette variante, la valeur du courant de chauffage circulant à travers la portion 106 de PCM dépend de la valeur d'un signal d'entrée, par exemple de 8 bits, appliqué sur une entrée 168 du convertisseur numérique - analogique 164.

La figure 13 représente une autre variante dans laquelle les convertisseurs numérique - analogique 164 fonctionnent en tension et imposent les valeurs des courants de chauffage circulant à travers la portion 106 de PCM via les valeurs des signaux délivrés en sortie 166 des convertisseurs 164 et appliqués sur les grilles des transistors MOS 124.

Afin de réduire les contraintes sur la taille des transistors, par exemple lorsqu'il n'est pas possible de réduire les dimensions des transistors pour réduire leurs capacités parasites, il est possible de coupler au commutateur 100 un dispositif de compensation 200 tel que représenté sur la figure 8.

Le dispositif 200 comporte un premier élément capacitif 202 dont une première électrode est connectée à la sortie 104 du commutateur 100, et un deuxième élément capacitif 204 dont une première électrode est connectée à l'entrée 102 du commutateur 100. Le dispositif 200 comprend de plus un premier inverseur 206 dont l'entrée est connectée à la deuxième électrode du condensateur 204 et dont la sortie est connectée à la deuxième électrode du condensateur 202, et, en antiparallèle de l'inverseur 206, un deuxième inverseur 208 dont l'entrée est connectée à la deuxième électrode du condensateur 202 et dont la sortie est connectée à la deuxième électrode du condensateur 204.

Les éléments capacitifs 202, 204 ont de préférence une capacité proche de la valeur de la capacité parasite destinée à être compensée, par exemple comprise entre 0,8 et 1,2 fois la valeur de cette capacité parasite.

Le dispositif 200 comporte également un élément résistif 210 servant de point de polarisation aux inverseurs 206, 208 lorsque le commutateur 100 est à l'état OFF.

L'ajout d'un tel dispositif 200 compensant les capacités parasites des transistors MOS destinés à activer ou désactiver les premières et deuxièmes sources de courant formées par le dispositif de commande 116 permet de réduire les contraintes pesant sur le dimensionnement des transistors, afin d'éviter la présence de fortes capacités parasites dans ces transistors MOS.

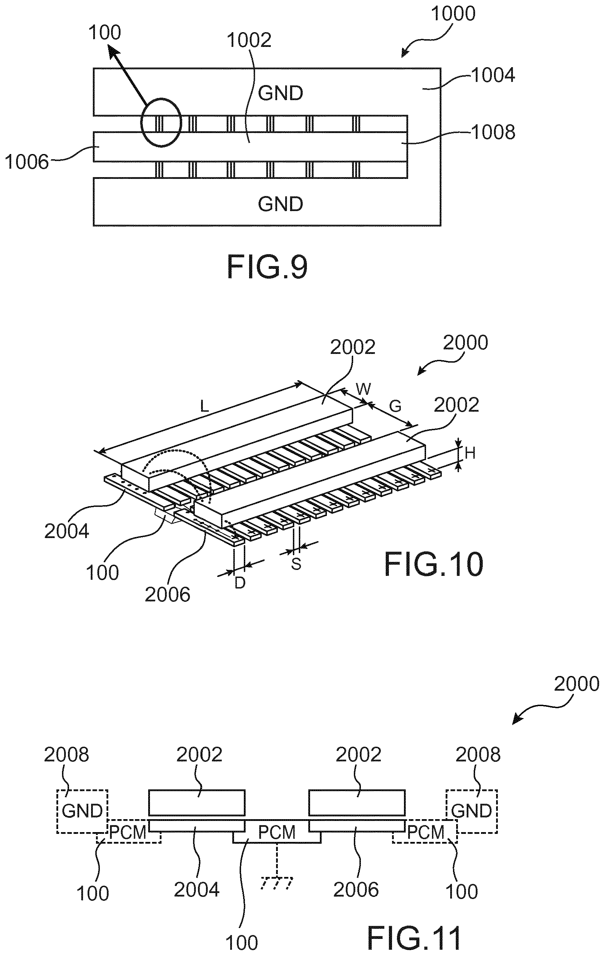

La figure 9 représente schématiquement un exemple de réalisation d'un dispositif 1000 d'adaptation d'une ligne de transmission, également appelé stub variable, comprenant plusieurs commutateurs 100 similaires à celui décrit précédemment. Le dispositif 1000 comporte une première ligne conductrice 1002, ou première portion de matériau électriquement conducteur, et une deuxième ligne conductrice 1004, ou deuxième portion électriquement conductrice, entre lesquelles plusieurs commutateurs 100 sont interposés. Les lignes conductrices 1002, 1004 et les portions 106 des commutateurs 100 sont avantageusement réalisées dans un même niveau d'interconnexions métalliques d'un circuit. La deuxième ligne 1004 entoure en partie la première ligne 1002. Une première extrémité 1006 de la première ligne conductrice 1002 est destinée à être reliée à la ligne de transmission (non visible sur la figure 9) dont l'impédance est destinée à être adaptée par le dispositif 1000. Une deuxième extrémité 1008 de la première ligne conductrice 1002 est reliée à la deuxième ligne conductrice 1004.

Les extrémités 108, 110 de la ou des portions de PCM 106 de chacun des commutateurs 100 sont couplées aux première et deuxième lignes conductrices 1002, 1004 à différentes distances de la première extrémité 1006 de la première ligne conductrice 1002 telle que la longueur d'adaptation du dispositif 1000 puisse être déterminée par la distance entre la première extrémité 1006 de la première ligne conductrice 1002 et le commutateur 100 se trouvant à l'état passant qui est le plus proche de la première extrémité 1006.

Par rapport à un dispositif d'adaptation utilisant des transistors pour déterminer la longueur d'adaptation du dispositif, l'utilisation des commutateurs 100 comportant des portions de PCM permet de réduire la valeur de résistance électrique du dispositif d'adaptation à l'état passant (Ron), augmentant ainsi le facteur de qualité pouvant être obtenu. Un tel dispositif d'adaptation utilisé par exemple au sein d'un amplificateur de puissance permet d'améliorer les qualités de cet amplificateur.

Les commutateurs 100 peuvent également être utilisés pour réaliser un système déphaseur d'une ligne de transmission différentielle 2000, utilisé par exemple au sein d'un réseau d'antennes. Un exemple de réalisation d'un tel système déphaseur RF 2000 est représenté sur les figures 10 et 11.

Ce système 2000 comporte une ligne de transmission différentielle formée de deux portions électriquement conductrices 2002. Les signaux RF sont destinés à traverser ses portions 2002 parallèlement à leur longueur L. Des premières lignes à retards 2004 sont disposées sous l'une des portions 2002, et des deuxièmes lignes à retards 2006 sont disposées sous l'autre des portions 2002. En fonction du nombre de lignes à retards 2004 reliées à la masse ou entre elles, l'onde transmise dans les portions 2002 est plus ou moins ralentie.

La connexion des lignes à retards 2004 entre elles est réalisée grâce aux commutateurs 100 en contact avec deux lignes à retards 2004 se trouvant chacune sous l'une des portions 2002. D'autres commutateurs 100 sont interposés entre chacune des lignes à retard 2004 et des portions conductrices 2008 reliées à la masse 2006. En variante, il est possible que la liaison à la masse des lignes à retards 2004, 2006 se fasse non pas via les portions conductrices 2008 et les commutateurs 100 reliés entre les lignes à retards 2004, 2006 et ces portions conductrices 2008, mais par une liaison à la masse directement formée sur les commutateurs 100 interposés entre les lignes à retards 2004, 2006.

**Revendications**

1.  Commutateur (100) comprenant au moins une portion (106) de PCM, apte à être dans un état passant ou bloqué en fonction de l'état, amorphe ou cristallin, du PCM qui est apte à changer d'état lorsqu'il est soumis à un chauffage, dans lequel la portion (106) de PCM est continue et de forme allongée telle qu'une entrée (102) et une sortie (104) du commutateur (100) soient reliées respectivement à deux extrémités (108, 110) de la portion (106) de PCM qui sont espacées l'une de l'autre d'une distance correspondant à la plus grande dimension de la portion (106) de PCM, et comportant un dispositif (116) de commande de l'état du commutateur (100) apte à faire circuler des courants de chauffage à travers la portion (106) de PCM, sensiblement perpendiculairement à la plus grande dimension de la portion (106) de PCM, depuis au moins deux points d'entrée (112), espacés l'un de l'autre et espacés des extrémités (108, 110) de la portion (106) de PCM, vers au moins deux points de sortie (114) espacés l'un de l'autre et espacés des extrémités (108, 110) de la portion (106) de PCM.

2. Commutateur (100) selon la revendication 1, dans lequel le dispositif (116) de commande comporte une pluralité de composants électroniques (118-130) formant des premières sources de courant (118, 120) chacune apte à injecter un des courants de chauffage dans la portion (106) de PCM depuis l'un des points d'entrée (112), et des deuxièmes sources de courant (122, 124, 126, 128, 130) chacune apte à extraire l'un des courants de chauffage depuis l'un des points de sortie (114).

3. Commutateur (100) selon la revendication 2, dans lequel les premières et deuxièmes sources de courant formées par les composants électroniques (118-130) du dispositif (116) de commande sont aptes à être commandées simultanément par un même signal de commande CTR.

4. Commutateur (100) selon la revendication 3, dans lequel chacune des premières sources de courant comporte au moins un transistor MOS (120) comportant l'une de ses électrodes de source et de drain reliée à l'un des points d'entrée (112) et l'autre de ses électrodes de source et de drain à un potentiel électrique d'alimentation, et dont la grille est apte à recevoir le signal de commande CTR.

5. Commutateur (100) selon l'une des revendications 3 ou 4, dans lequel chacune des deuxièmes sources de courant comporte au moins plusieurs transistors MOS (122, 124, 126, 128) montés en miroir de courant, au moins l'un (122, 126) desdits transistors MOS comportant sa grille apte à recevoir le signal de commande CTR.

6. Commutateur (100) selon la revendication 5, dans lequel chacune des deuxièmes sources de courant comporte en outre au moins un élément résistif (130) couplé au miroir de courant et apte à former une résistance ayant une première ou une deuxième valeurs, différentes l'une de l'autre et telles que la valeur du courant de chauffage extrait par la deuxième source de courant soit adaptée en fonction de l'état du commutateur (100) destiné à être commandé par le dispositif (116) de commande.

7. Commutateur (100) selon l'une des revendications 3 ou 4, dans lequel les deuxièmes sources de courant sont formées par au moins un convertisseur numérique - analogique.

8. Commutateur (100) selon l'une des revendications précédentes, dans lequel la portion (106) de PCM a une forme parallélépipédique rectangle de longueur supérieure à sa largeur et à son épaisseur.

9. Commutateur (100) selon la revendication 8, dans lequel les points d'entrée (112) et de sortie (114) sont disposés sur des faces latérales de la portion (106) de PCM espacées l'une de l'autre d'une distance correspondant à sa largeur.

10. Commutateur (100) selon l'une des revendications précédentes, comportant plusieurs portions (106) de PCM disposées sensiblement parallèlement les unes à côté des autres, le dispositif (116) de commande étant apte à faire circuler des courants de chauffage à travers chacune des portions (106) de PCM, sensiblement perpendiculairement à la plus grande dimension de chacune des portions (106) de PCM, depuis au moins deux points d'entrée (112), espacés l'un de l'autre et espacés des extrémités (108, 110) de chacune des portions (106) de PCM, vers au moins deux points de sortie (114) espacés l'un de l'autre et espacés des extrémités (108, 110) de chacune des portions (106) de PCM.

11. Commutateur (100) selon l'une des revendications 2 à 10, comportant en outre, lorsque le dispositif (116) de commande comporte la pluralité de composants électroniques (118-130) formant des premières et deuxièmes sources de courant, un dispositif (200) couplé aux extrémités (108, 110) de la ou des portions (106) de PCM et apte à compenser des capacités parasites de transistors MOS (120, 122, 126) destinés à activer ou désactiver les premières et deuxièmes sources de courant.

12. Commutateur (100) selon l'une des revendications 2 à 11, dans lequel, lorsque le dispositif (116) de commande comporte la pluralité de composants électroniques (118-130) formant des premières et deuxièmes sources de courant, lesdits composants électroniques (118-130) comportent des zones actives formées dans au moins une couche de semi-conducteur, et dans lequel la portion (106) de PCM est disposée au sein d'un niveau d'interconnexions métalliques se trouvant au-dessus de la couche de semi-conducteur et espacée de la couche de semi-conducteur par au moins un diélectrique intercouche.

13. Dispositif (1000) d'adaptation d'une ligne de transmission, comprenant au moins :

- une première portion (1002) de matériau électriquement conducteur comprenant une première extrémité (1006) destinée à être reliée à la ligne de transmission et une deuxième extrémité (1008) reliée à au moins une deuxième portion (1004) de matériau électriquement conducteur destinée à être reliée à un potentiel de référence,
- une pluralité de commutateurs (100) selon l'une des revendications 1 à 12, les extrémités (108, 110) de la ou des portions (106) de PCM de chacun des commutateurs (100) étant couplées aux première et deuxième portions (1002, 1004) de matériau électriquement conducteur à différentes distances par rapport à la première extrémité (1006) de la première portion (1002) de matériau électriquement conducteur telles que la longueur d'adaptation du dispositif (1000) soit apte à être définie par la distance entre la première extrémité (1006) de la première portion (1002) de matériau électriquement conducteur et le commutateur (100) à l'état passant le plus proche de la première extrémité (1006) de la première portion (1002) de matériau électriquement conducteur.

14. Dispositif (2000) déphaseur d'une ligne de transmission différentielle (2002), comprenant au moins :

- plusieurs premières lignes à retard (2004) destinées à être couplées à une première portion électriquement conductrice de la ligne de transmission différentielle (2002),
- plusieurs deuxièmes lignes à retard (2006) destinées à être couplées à une deuxième portion électriquement conductrice de la ligne de transmission différentielle (2002),
- plusieurs commutateurs (100) selon l'une des revendications 1 à 12, les extrémités (108, 110) de la ou des portions (106) de PCM de chacun des commutateurs (100) étant couplées à l'une des premières lignes à retard (2004) et à l'une des deuxièmes lignes à retard (2006) telles que lesdites première et deuxième lignes à retard (2004, 2006) soient aptes à être reliées électriquement l'une à l'autre lorsque le commutateur (100) est à l'état passant et aptes à être reliées à un potentiel électrique de référence lorsque le commutateur (100) est à l'état bloqué.

**Patentansprüche**

1. Schalter (100), umfassend wenigstens einen Bereich (106) aus PCM, der dazu ausgelegt ist, als Funktion des amorphen oder kristallinen Zustands des PCM, das dazu ausgelegt ist, seinen Zustand zu ändern, wenn es einer Aufheizung ausgesetzt wird, in einem passierenden oder blockierenden Zustand zu sein, wobei der Bereich (106) aus PCM kontinuierlich und von länglicher Form derart ist, dass ein Eingang (102) und ein Ausgang (104) des Schalters (100) mit zwei jeweiligen Enden (108, 110) des Bereichs (106) aus PCM verbunden sind, die voneinander um einen Abstand beabstandet sind, der der größten Abmessung des Bereichs (106) aus PCM entspricht, und umfassend eine Vorrichtung (116) zur Steuerung des Zustands des Schalters (100), die dazu ausgelegt ist, Heizströme durch den Bereich (106) aus PCM hindurch im Wesentlichen orthogonal zur größten Abmessung des Bereichs (106) aus PCM von wenigstens zwei Eingangspunkten (112), die voneinander beabstandet sind und von den Enden (108, 110) des Bereichs (106) aus PCM beabstandet sind, in Richtung von wenigstens zwei Ausgangspunkten (114) zirkulieren zu lassen, die voneinander beabstandet sind und von den Enden (108, 110) des Bereichs (106) aus PCM beabstandet sind.

2. Schalter (100) nach Anspruch 1, bei dem die Vorrichtung (116) zur Steuerung eine Mehrzahl von elektronischen Komponenten (118-130) umfasst, die erste Stromquellen (118, 120) bilden, die jeweils dazu ausgelegt sind, einen der Heizströme in den Bereich (106) aus PCM von einem der Eingangspunkte (112) aus zu injizieren, sowie zweite Stromquellen (122, 124, 126, 128, 130), die jeweils dazu ausgelegt sind, einen der Heizströme von einem der Ausgangspunkte (114) zu extrahieren.

3. Schalter (100) nach Anspruch 2, bei dem die ersten und zweiten Stromquellen, die gebildet sind durch die elektronischen Komponenten (118-130) der Vorrichtung (116) zur Steuerung, dazu ausgelegt sind, gleichzeitig durch ein und dasselbe CTR-Steuersignal gesteuert zu werden.

4. Schalter (100) nach Anspruch 3, bei dem jede der ersten Stromquellen wenigstens einen MOS-Transistor (120) umfasst, umfassend eine seiner Source- und Drain-Elektroden verbunden mit einem der Eingangspunkte (112) und die andere seiner Source- und Drain-Elektroden mit einem elektrischen Versorgungspotential, und dessen Gate dazu ausgelegt ist, das CTR-Steuersignal zu empfangen.

5. Schalter (100) nach einem der Ansprüche 3 oder 4, bei dem jede der zweiten Stromquellen wenigstens mehrere MOS-Transistoren (122, 124, 126, 128) umfasst, die als Stromspiegel montiert sind, wobei wenigstens einer (122, 126) der MOS-Transistoren ein Gate umfasst, das dazu ausgelegt ist, das CTR-Steuersignal zu empfangen.

6. Schalter (100) nach Anspruch 5, bei dem jede der zweiten Stromquellen ferner wenigstens ein Widerstandselement (130) umfasst, das mit dem Stromspiegel gekoppelt und dazu ausgelegt ist, einen Widerstand zu bilden, der einen ersten oder einen zweiten Wert hat, die voneinander verschieden sind und derart, dass der Wert des Heizstroms, der von der zweiten Stromquelle extrahiert wird, als Funktion des Zustands des Schalters (100) angepasst wird, der durch die Vorrichtung (116) zur Steuerung gesteuert werden soll.

7. Schalter (100) nach einem der Ansprüche 3 oder 4, bei dem die zweiten Stromquellen durch wenigstens einen Digital-Analog-Wandler gebildet sind.

8. Schalter (100) nach einem der vorhergehenden Ansprüche, bei dem der Bereich (106) aus PCM eine rechtwinklige Parallelepipedform mit einer Länge hat, die größer als ihre Breite und ihre Dicke ist.

9. Schalter (100) nach Anspruch 8, bei dem die Eingangspunkte (112) und die Ausgangspunkte (114) auf lateralen Flächen des Bereichs (106) aus PCM angeordnet sind, die voneinander um einen Abstand entsprechend seiner Breite beabstandet sind.

10. Schalter (100) nach einem der vorhergehenden Ansprüche, umfassend mehrere Bereiche (106) aus PCM, die im Wesentlichen parallel nebeneinander angeordnet sind, wobei die Vorrichtung (116) zur Steuerung dazu ausgelegt ist, Heizströme durch jeden der Bereiche (106) aus PCM im Wesentlichen orthogonal zur größten Abmessung jedes der Bereiche (106) aus PCM von wenigstens zwei Eingangspunkten (112), die voneinander beabstandet sind und von den Enden (108, 110) jedes der Bereiche (106) aus PCM beabstandet sind, in Richtung von wenigstens zwei Ausgangspunkten (114) zirkulieren zu lassen, die voneinander beabstandet sind und von den Enden (108, 110) jedes der Bereiche (106) aus PCM beabstandet sind.

11. Schalter (100) nach einem der Ansprüche 2 bis 10, ferner umfassend dann, wenn die Vorrichtung (116) zur Steuerung die Mehrzahl von elektronischen Komponenten (118-130) umfasst, die erste und zweite Stromquellen bilden, eine Vorrichtung (200), die mit den Enden (108, 110) des Bereichs oder der Bereiche (106) aus PCM gekoppelt und dazu ausgelegt ist, parasitäre Kapazitäten von MOS-Transistoren (120, 122, 126) zu kompensieren, die die ersten und zweiten Stromquellen aktivieren oder deaktivieren sollen.

12. Schalter (100) nach einem der Ansprüche 2 bis 11, bei dem dann, wenn die Vorrichtung (116) zur Steuerung die Mehrzahl von elektronischen Komponenten (118-130) umfasst, die erste und zweite Stromquellen bilden, die elektronischen Komponenten (118-130) aktive Zonen umfassen, die in wenigstens einer Halbleitschicht gebildet sind, und wobei der Bereich (106) aus PCM innerhalb eines Niveaus von metallischen Zwischenverbindungen angeordnet ist, das sich über der Halbleiterschicht befindet, und von der Halbleiterschicht durch wenigstens eine dielektrische Zwischenschicht beabstandet ist.

13. Vorrichtung (1000) zur Anpassung einer Übertragungsleitung, umfassend wenigstens Folgendes:

- einen ersten Bereich (1002) aus elektrisch leitendem Material, umfassend ein erstes Ende (1006), das dazu ausgelegt ist, mit der Übertragungsleitung verbunden zu sein, sowie ein zweites Ende (1008), das mit wenigstens einem zweiten Bereich (1004) aus elektrisch leitendem Material verbunden ist, der dazu ausgelegt ist, mit einem Referenzpotential verbunden zu sein,
- eine Mehrzahl von Schaltern (100) nach einem der Ansprüche 1 bis 12, wobei die Enden (108, 110) des oder der Bereiche (106) aus PCM von jedem der Schalter (100) mit dem ersten und dem zweiten Bereich (1002, 1004) aus elektrische leitendem Material in verschiedenen Abständen bezogen auf das erste Ende (1006) des ersten Bereichs (1002) aus elektrisch leitendem Material derart gekoppelt sind, dass die Anpassungslänge der Vorrichtung (1000) durch den Abstand zwischen dem ersten Ende (1006) des ersten Bereichs (1002) aus elektrisch leitendem Material und dem Schalter (100) im passierenden Zustand, der dem ersten Ende (1006) des ersten Bereichs (1002) aus elektrisch leitendem Material am nächsten ist, definiert werden kann.

14. Phasenschiebervorrichtung (2000) für eine differentielle Übertragungsleitung (2002) umfassend wenigstens Folgendes:

- mehrere erste Verzögerungsleitungen (2004), die dazu ausgelegt sind, mit einem ersten elektrisch leitenden Bereich der differentiellen Übertragungsleitung (2002) gekoppelt zu sein,
- mehrere zweite Verzögerungsleitungen (2006), die dazu ausgelegt sind, mit einem zweiten elektrisch leitenden Bereich der differentiellen Übertragungsleitung (2002) gekoppelt zu sein,
- mehrere Schalter (100) nach einem der Ansprüche 1 bis 12, wobei die Enden (108, 110) des oder der Bereiche (106) aus PCM von jedem der Schalter (100) mit einer der ersten Verzögerungsleitungen (2004) und mit einer der zweiten Verzögerungsleitungen (2006) derart gekoppelt sind, dass die ersten und zweiten Verzögerungsleitungen (2004, 2006) elektrisch miteinander verbunden werden können, wenn der Schalter (100) im passierenden Zustand ist, und mit einem elektrischen Referenzpotential verbunden werden können, wenn der Schalter (100) im blockierenden Zustand ist.

**Claims**

1. Switch (100) comprising at least one PCM portion (106) that can be in a conducting or blocked state depending on the amorphous or crystalline state of the PCM that can change state when it is heated, in which the PCM portion (106) is continuous and has an elongated shape such that an input (102) and an output (104) of the switch (100) are connected to two ends (108, 110) of the PCM portion (106) respectively that are spaced at a distance from each other corresponding to the largest dimension of the PCM portion (106), and comprising a device (116) to control the state of the switch (100) capable of passing heating currents through the PCM portion (106), approximately perpendicular to the largest dimension of the PCM portion (106), from at least two input points (112) at a distance from each other and at a distance from the ends (108, 110) of the PCM portion (106), to at least two output points (114) at a distance from each other and at a distance from the ends (108, 110) of the PCM portion (106).

2. The switch (100) according to claim 1, in which the control device (116) comprises a plurality of electronic components (118-130) that form first current sources (118, 120) each capable of injecting one of the heating currents into the PCM portion (106) from one of the input points (112), and second current sources (122, 124, 126, 128, 130) each capable of extracting one of the heating currents from one of the output points (114).

3. The switch (100) according to claim 2, in which the first and second current sources formed by the electronic components (118-130) of the control device (116) can be controlled simultaneously by the same control signal CTR.

4. The switch (100) according to claim 3, in which each of the first current sources comprises at least one MOS transistor (120) comprising one of its source and drain electrodes connected to one of the input points (112) and the other of its source and drain electrodes to an electrical power supply voltage, and in which the gate can receive the control signal CTR.

5. The switch (100) according to one of claims 3 or 4, in which each of the second current sources comprises at least several MOS transistors (122, 124, 126, 128) mounted in current mirror, at least one (122, 126) of said MOS transistors having its gate that can receive the control signal CTR.

6. The switch (100) according to claim 5, in which each of the second current sources also comprises at least one resistive element (130) coupled to the current mirror and capable of forming a resistance with a first or a second value, different from each other and such that the value of the heating current extracted by the second current source is adapted as a function of the state of the switch (100) that will be controlled by the control device (116).

7. The switch (100) according to one of claims 3 or 4, in which each of the second current sources are formed from at least one digital - analogue converter.

8. The switch (100) according to one of previous claims, in which the PCM portion (106) is in the form of a rectangular parallelepiped with a length greater than its width and its thickness.

9. The switch (100) according to claim 8, in which the input points (112) and output points (114) are located on side faces of the PCM portion (106), separated from each other by a distance equal to its width.

10. The switch (100) according to one of previous claims, comprising several PCM portions (106) located side by side and approximately parallel to each other, the control device (116) being capable of passing heating currents through each of the PCM portions (106), approximately perpendicular to the largest dimension of each of the PCM portions (106), from at least two input points (112) separated from each other and separated from the ends (108, 110) of each of the PCM portions (106), to at least two output points (114) separated from each other and separated from the ends (108, 110) of each of the PCM portions (106).

11. The switch (100) according to one of claims 2 to 10, further comprising, when the control device (116) comprises the plurality of electronic components (118-130) forming first and second current sources, a device (200) coupled to the ends (108, 110) of the PCM portions (106) and capable of compensating for parasite capacitances of MOS transistors (120, 122, 126) that will activate or deactivate the first and second current sources.

12. The switch (100) according to one of claims 2 to 11, in which, when the control device (116) comprises the plurality of electronic components (118-130) forming first and second current sources, said electronic components (118-130) comprise active zones formed in at least one semiconducting layer, and in which the PCM portion (106) is located within a metallic interconnections level located above the semiconducting layer and separated from the semiconducting layer by at least one interlayer dielectric.

13. A transmission line matching device (1000), comprising at least:

- a first portion (1002) of electrically conducting material comprising a first end (1006) that will be connected to the transmission line and a second end (1008) connected to at least one second portion (1004) of the electrically conducting material that will be connected to a reference potential,
- a plurality of switches (100) according to one of claims 1 to 12, the ends (108, 110) of the PCM portions (106) of each of the switches (100) being coupled to the first and second portions (1002, 1004) of electrically conducting material at different distances from the first end (1006) of the first portion (1002) of electrically conducting material such that the matching length of the device (1000) can be defined by the distance between the first end (1006) of the first portion (1002) of electrically conducting material and the switch (100) in the conducting state closest to the first end (1006) of the first portion (1002) of electrically conducting material.

14. A phase shift device (2000) for a differential transmission line (2002), comprising at least:

- several first delay lines (2004) intended to be coupled to a first electrically conducting portion of the differential transmission line (2002);
- several second delay lines (2006) intended to be coupled to a second electrically conducting portion of the differential transmission line (2002);
- several switches (100) according to one of claims 1 to 12, the ends (108, 110) of the PCM portions (106) of each of the switches (100) being coupled to one of the first delay lines (2004) and to one of the second delay lines (2006) such that said first and second delay lines (2004, 2006) can be electrically connected to each other when the switch (100) is in the conducting state and can be connected to a reference electrical potential when the switch (100) is in the blocked state.

FIG.1

FIG.2

FIG.3

FIG.4

FIG.5

FIG.6

108 110

160 146 148 162

FIG.7

100

102 106 104

204 202

210

208

206

200

FIG.8

FIG.9

FIG.10

FIG.11

FIG.12

116

118

120

110

CTR

112

108

114

CTR

122

164

168

166

8 bits

FIG.13

116

118

120

110

CTR

112

108

114

CTR

122

124

164

168

166

8 bits

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2008007995 A

**Littérature non-brevet citée dans la description**

- **Y. SHIM et al.** RF switches using phase change materials. *Proc. IEEE Int. Conf. Microelectromech. Syst.,* Janvier 2013, 237-240
- **M. WANG et al.** Directly heated four-terminal phase change switches. *Proc. IEEE MTT-S Int. Microw. Symp.,* Juin 2014, 1-4

- A Four-Terminal, Inline, Chalcogenide Phase-Change RF Switch Using an Independent Resistive Heater for Thermal Actuation. **N. EL-HIN-NAWY et al.** Electron Device Letters. IEEE, 2013, vol. 34, 1313-1315